# EUROPÄISCHE PATENTSCHRIFT

(11) **EP 1 015 896 B1**
(45) Veröffentlichungstag und Bekanntmachung des Hinweises auf die Patenterteilung: **05.03.2003**
(21) Anmeldenummer: 98946460.7
(22) Anmeldetag: 17.09.1998
(51) Int. Cl.: G01R 15/20

(54) **STROMMESSGERÄT MIT HALLSENSOR**
CURRENT MEASURING ELEMENT WITH A HALL SENSOR
AMPEREMETRE AVEC DETECTEUR A EFFET HALL

(30) Priorität: 19.09.1997 DE 19741417
(43) Veröffentlichungstag der Anmeldung: 05.07.2000
(73) Patentinhaber: Bruchmann, Klaus, D-96450 Coburg (DE)
(72) Erfinder: Bruchmann, Klaus, D-96450 Coburg (DE)
(74) Vertreter: Groening, Hans Wilhelm, Dipl.-Ing.
(86) Internationale Anmeldenummer: EP9805912
(87) Internationale Veröffentlichungsnummer: WO99015907

(56) Entgegenhaltungen:
- EP-A- 0 675 368
- DE-A- 3 428 392
- DE-A- 19 549 181
- DE-U- 9 113 081
- US-A- 5 642 041

## Beschreibung

Die Erfindung betrifft ein Strommeßgerät mit einem stromdurchflossenen Leiter in einem isolierenden Gehäuse und einem in der Nähe des Leiters angeordneten Hallsensor. Ein solches Strommeßgerät ist zum Beispiel in der EP 0 538 658 A1 beschrieben.

Hallsensoren können bekanntlich dazu herangezogen werden, berührungsfrei den in einem Leiter fließenden Strom zu messen. Um das Magnetfeld des Stromes, das für den Hall-Effekt verantwortlich ist, zu konzentrieren und störende Einflüsse auszuschalten, werden in der Regel ferromagnetische Elemente mit einem Luftspalt verwendet, in dem der Hallsensor angeordnet ist.

Bei dem in der oben genannten Druckschrift EP 0 538 658 beschriebenen Strommeßgerät, das in Leistungsschaltern und Motorschutzschaltern Verwendung finden kann, fließt der Strom durch eine in zwei Hälften geteilte Spule, in deren gemeinsamen Spulenkörper eine Tasche zur Aufnahme der integrierten Hallschaltung vorgesehen ist.

Aus der DE-A-34 28 392 ist ein ähnliches Strommeßgerät bekannt, bei dem ein stromdurchflossener Leiter in Form einer Spule oder einer gebogenen Schiene einen Hallsensor umgibt und seinerseits von einem ferromagnetischen Kern zur Konzentration des Magnetfeldes umgeben ist.

Solche Ausführungen des Strommeßgerätes mit Spulen und ferromagnetischen Kernen und dergleichen haben den Nachteil, daß wegen der Spulen und Kerne der Aufbau recht groß und schwer ist.

Aus der DE-A-195 49 181 ist ein Strommeßgerät bekannt, bei dem ein Hallsensor ohne Zwischenschaltung eines ferromagnetischen Kerns zwischen die Schenkel einer U-förmigen Leiterschleife eingebracht ist. Dieses Meßgerät weist jedoch keine Abschirmung auf, ist daher relativ ungenau und eignet sich zumindest nicht für die Starkstrommessung.

Aus der EP 0 675 368 A1 ist ferner ein Eingangsteil eines Meßgerätes bekannt, das eine Vorrichtung zur Messung eines durch einen Strompfad hervorgerufenen Magnetfeldes offenbart. Diese Vorrichtung weist einen Kunststoffträger auf, der sowohl Strompfade positioniert als auch Klammern aufweist, die eine Platine halten, auf der Hallsensoren zur Strommessung befestigt sind. Diese Kunststoffträger dienen ausschließlich als mechanisches Bauteil und bewirken keine galvanische Trennung zwischen Strompfaden und Sensorbausteinen, weil weder die Strompfade noch der Sensorbaustein vollstädig umschlossen sind.

Es ist daher Aufgabe der Erfindung, eine Strommeßgerät mit einem stromdurchflossenen Leiter gemäß dem Oberbegriff des Anspruches 1 zur Verfügung zu stellen, bei dem eine vollständige galvanische Trennung des Bereiches hoher Spannung und Ströme von den elektronischen Bauteilen sichergestellt ist. Ferner ist es Aufgabe der Erfindung, eine ausreichende Genauigkeit des Strommeßgerätes zu gewährleisten. Diese Aufgabe wird erfindungsgemäß durch ein Strommeßgerät gemäß Anspruch 1 gelöst, die Ansprüche 2 bis 5 betreffen besonders vorteilhafte Ausführungsformen des erfindungsgemäßen Strommeßgerätes.

Im Falle eines Verzichts auf eine Spule und einen ferromagnetischen Kern oder ein anderes ferromagnetisches Element vereinfacht sich nicht nur der Aufbau des Strommeßgerätes, sondern es entsteht im Betrieb wegen der nicht mehr auftretenden Übertragungsverluste auch deutlich weniger Wärme. Gerade bei einer Verwendung in Schaltkästen ist dies von erheblicher Bedeutung.

Die beiden antiparallel durchflossenen Strombahnen in der U-förmigen Leiterschleife aus flachen Stromschienen bewirken nahezu eine Verdoppelung des Magnetfeldes und damit des Signals vom Hallsensor.

Das erfindungsgemäße Strommeßgerät zur berührungsfreien Strommessung ist so klein, daß es ohne weiteres in Meßboxen und Schaltgeräte eingebaut werden kann. In das erfindungsgemäße Strommeßgerät ist die Elektronik zur Verstärkung des gemessenen Signals, dessen Auswertung, eine Temperaturkompensation sowie ggf. eine Steuerlogik und eine Digitalanzeige bereits integriert.

Der vollständig geschlossene, isolierende Deckel zwischen dem Gehäuse mit dem stromführenden Leiter und der Platine mit den Hallsensoren und der Auswerteelektronik sorgt für eine vollständige galvanische Trennung des Hochspannungsbereiches von den elektronischen Bauteilen.

Die wahlweise vorgesehene metallische Abschirmung um die U-förmige Leiterschleife verringert den Einfluß störender Magnetfelder auf den Hallsensor.

Das erfindungsgemäße Strommeßgerät mit Hallsensor wird im folgenden anhand der Zeichnung beispielhaft näher erläutert. Es zeigen:
Fig. 1 den Aufbau des Strommeßgerätes; und
Fig. 2 die Platine mit dem Hallsensor im Detail.
Fig. 3 ein Blockschaltbild für die Signalverarbeitung im Strommessgerät

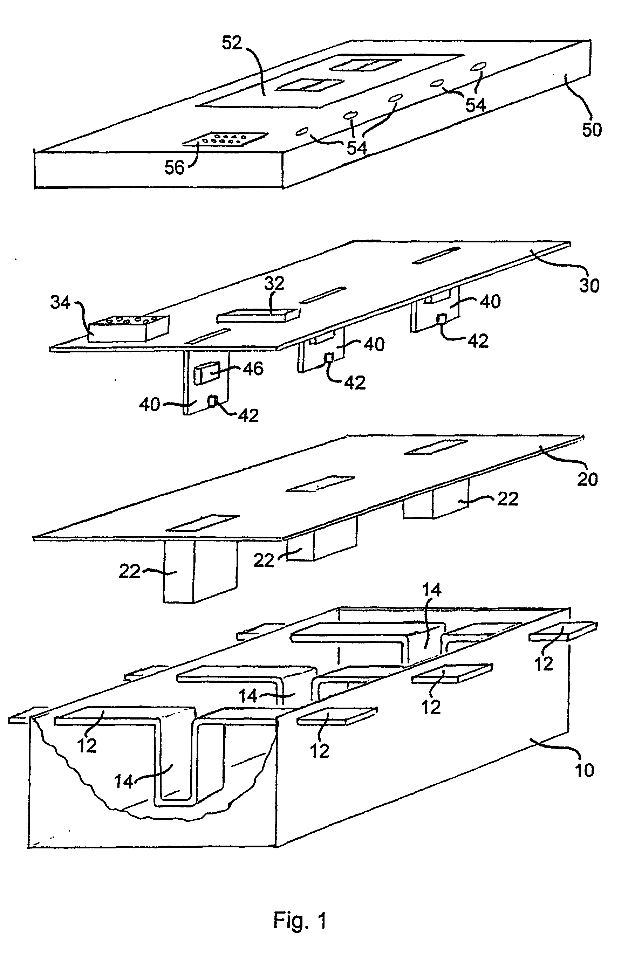

In der Fig. 1 ist der Aufbau des Strommeßgerätes in einer auseinandergezogenen Darstellung gezeigt. Das Strommeßgerät besteht aus einem isolierenden Gehäuse 10 für einen oder mehrere stromführende Leiter 12 in der Form von flachen Schienen in der Art, wie sie in der Starkstromtechnik üblich sind. Das in der Fig. 1 dargestellte Gehäuse 10 umfaßt drei parallel verlaufende Leiter 12 für die dreiphasige Stromversorgung eines Verbraucher, z.B. eines Motors.

Das gezeigte Strommeßgerät ist für die Verwendung im Niederspannungs-Starkstrombereich bei Stromstärken bis zu etwa 150 A vorgesehen. Die kleinste Stromstärke, die vom Meßgerät noch erfaßt werden soll, liegt bei 0,1 bis 1 A.

Die Leiter 12 sind am Eingang und am Ausgang des Gehäuses 10 mit (nicht gezeigten) Anschlußelementen versehen, damit jeder der Leiter 12 in die entsprechende Stromzuführung geschaltet werden kann. Ebenfalls nicht gezeigt ist die eingangsseitige und ausgangsseitige isolierende Abdeckung der Leiter 12 und der Anschlußelemente.

Im Gehäuse 10 ist jeder der flachen, schienenförmigen Leiter 12 U-förmig derart umgebogen, daß sich eine oben offene Leiterschleife 14 ergibt. Die U-förmige Leiterschleife 14 erstreckt sich aus der Ebene des flachen Leiters 12 heraus nach unten, das heißt sie liegt nicht in der Ebene des flachen Leiters 12, sondern verläuft senkrecht dazu. Die Leiterschleife 14 weist für eine Breite der Stromleiterschiene 12 von 12 mm zum Beispiel eine Tiefe von etwa 15 mm und einen inneren Abstand der Schenkel des U von etwa 5 bis 8 mm auf.

Jede der U-förmigen Leiterschleifen 14 kann auf der Außenseite, das heißt im Bereich des Gehäuses 10 unterhalb des Leiters 12 und der Leiterschleife 14, von einer (nicht gezeigten) metallischen Abschirmung umgeben sein, die den Einfluß störender äußerer Magnetfelder auf die Strommessung veringert oder aufhebt. Vorzugsweise besteht die Abschirmung aus Weicheisen (Mu-Metall); für bestimmte Anwendungen kann jedoch auch ein ganz normales Eisenblech ausreichen, um den gewünschten Abschirmeffekt zu erzielen.

Auf das Gehäuse 10 ist oben ein Deckel 20 aus isolierendem Material aufgesetzt. Der Deckel 20 schließt das Gehäuse 10 mit den stromführenden Leitern 12 berührungssicher ab.

Im Deckel 20 sind im Bereich der Leiterschleifen 14 Taschen 22 vorgesehen, die ebenfalls aus isolierendem Material sind. Die Taschen 22 stehen vom Deckel 20 nach unten vor und liegen bei aufgesetztem Deckel 20 jeweils innerhalb der Leiterschleifen 14. Die Taschen 22 sind oben, in der Höhe der Hauptebene des Deckels 20, offen, unten, im Bereich der Leiterschleife 14, jedoch allseits geschlossen. Die Breite jeder Tasche 22 entspricht ziemlich genau dem Schenkelabstand der Leiterschleife 14, so daß die Außenseiten der Tasche 22 nur einen geringen Abstand zu den seitlichen Schenkeln der Leiterschleife 14 haben oder auch sogar daran anliegen. Die Tiefe der Taschen 22 ist kleiner als die Tiefe der Leiterschleife 14. Die Länge der Taschen 22 (in Richtung der Breite der Leiterschiene 12) kann größer, gleich oder kleiner wie die Breite der Leiterschienen 12 sein.

Über dem Deckel 20 ist eine Hauptplatine 30 angeordnet. Die Hauptplatine 30 liegt mit geringem Abstand abnehmbar auf dem Deckel 20 auf.

Senkrecht zur Hauptebene der Hauptplatine 30 sind an der Hauptplatine 30 kleine Platinen 40 befestigt, die so angeordnet sind, daß sie sich in die Taschen 22 des Deckels 20 erstrecken, wenn die Hauptplatine 30 auf den Deckel 20 aufgesetzt ist.

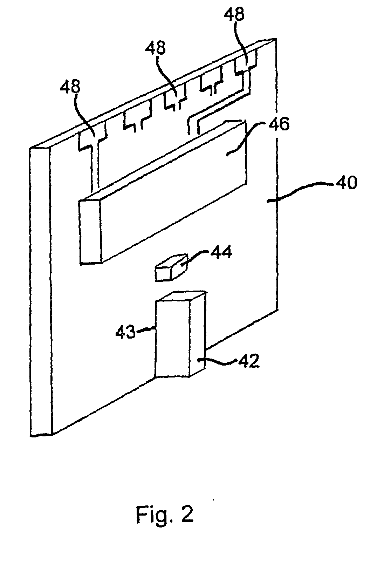

An den kleinen Platinen 40 sind Hallsensoren 42 befestigt. Wie in der Fig. 2 gezeigt, sind die Hallsensoren 42 derart in Einschnitten 43 etwa in der Mitte der unteren, freien Seite bzw. Kante der kleinen Platinen 40 angebracht, daß sich die Hallsensoren 42 mittig in den Taschen 22 des Deckels 20 und etwa mittig in den Stromschleifen 14 befinden, wenn die Platine 30, der Deckel 20 und das Gehäuse 10 zusammengesetzt sind. Die Hallsensoren 42 sind dabei so angeordnet, daß das Magnetfeld der Stromschleife 14 das Hall-Element in den Hallsensoren 42 senkrecht durchsetzt. Die Hauptebene des Hallsensors 42 verläuft somit senkrecht zur Hauptebene der kleinen Platine 40. Der genau für den Hallsensor 42 passende Einschnitt 43 in der Platine 40 an deren Unterseite erleichtert das richtige Plazieren des Hallsensors 42 und sorgt dafür, daß der Hallsensor 42 seine Lage beibehält.

In unmittelbarer Nähe des Hallsensors 42 ist auf der Platine 40 ein Temperaturfühler 44 vorgesehen, etwa ein NTC-Temperaturfühler. Außerdem befindet sich auf der Platine 40 ein Verstärker 46, der das Signal des Hallsensors 42 verstärkt. Über Leiterbahnen 48 werden die verstärkten Signale des Hallsensors 42 und die Signale des Temperatursensors 44 zur Hauptplatine 30 geführt.

Auf der Hauptplatine 30 werden die Signale von den Hallsensoren 42 und die Signale der Temperaturfühler 44 weiter verarbeitet. Dazu sind auf der Hauptplatine 30 die erforderlichen elektrischen und elektronischen Bauteile angeordnet, etwa integrierte Schaltungen 32, Widerstände, Dioden, Relais usw. (nur teilweise in der Fig. 1 dargestellt). vorzugsweise umfaßt die Hauptplatine 30 einen Mikroprozessor.

Mit dem Signal vom Temperaturfühler 44 wird das Signal des Hallsensors 42 temperaturkompensiert. Da sich der Temperaturfühler 44 in unmittelbarer Nähe des Hallsensors 42 befindet, wird dessen Temperatur sehr genau erfaßt. Aus dem temperaturkorrigierten Signal des Hallsensors 42 läßt sich der im Leiter 12 fließende Strom genau bestimmen.

Über der Hauptplatine 30 mit den kleinen Platinen 40 befindet sich eine Abdeckung 50. Die Abdeckung 50 weist an ihrer Vorderseite (der Außenseite) eine LCD-Anzeige 52, Knöpfe 54 für die Eingabe von Befehlen, Größen usw. und Stecker 56 für externe Anschlüsse auf. Die Abdeckung 50 steht mit der Hauptplatine 30 elektrisch über interne Stecker 34 auf der Hauptplatine oder/und über Kabel in Verbindung.

Mit den Knöpfen 54 läßt sich der Mikroprozessor auf der Hauptplatine 30 menügesteuert in bestimmte Betriebsarten bringen. So können etwa auf der LCD-Anzeige abwechselnd die Ströme in den einzelnen Phasenleitungen, die zugeführte (Gesamt-)Leistung und andere Größen wie Soll- und Istwerte dargestellt werden. Auch läßt sich das Strommeßgerät durch die Vorgabe von Strom- und Zeitsollwerten als Schutzschalter verwenden, wobei Abschaltbefehle und dergleichen über den externen Stecker 56 abgenommen werden können. Die Hauptplatine 30 kann auch Relais und Steuerklemmen enthalten, die die Schaltsignale konditionieren und weitergeben.

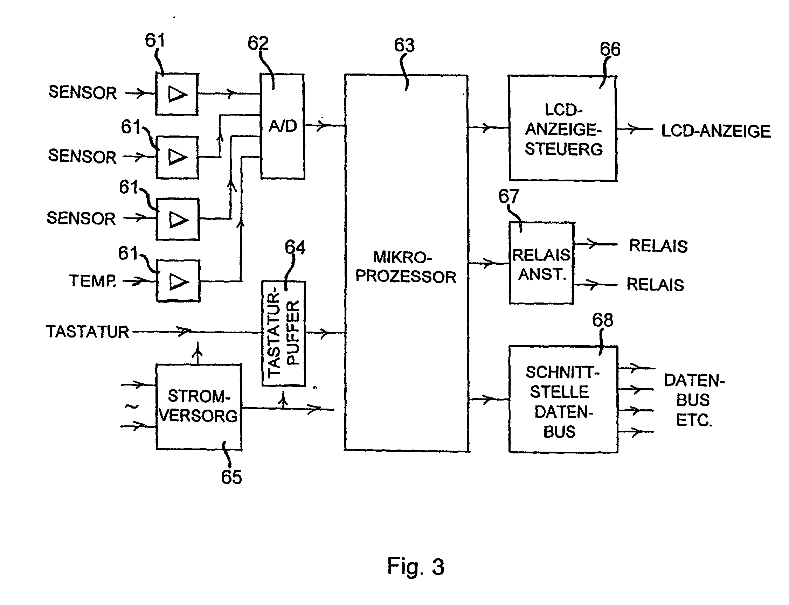

Die Fig. 3 zeigt ein Blockschaltbild für die Elektronikkomponenten des Strommeßgeräts. In der schematischen Darstellung der Fig. 3 ist die Verarbeitung der Signale von den Hallsensoren 42 und den Temperaturfühlern 44, der Eingangssignale von den Knöpfen 54 und dem Stecker 56 und der Ausgangssignale an die LCD-Anzeige 52, den Stecker 56 usw. zusammengefaßt. Die Signalverarbeitung erfolgt nicht nur auf der Hauptplatine 30, sondern teilweise auch auf den kleinen Platinen 40 mit den Hallsensoren 42 und gegebenenfalls anderen, nicht auf der Hauptplatine 30 angeordneten Bauelementen, etwa im LCD-Anzeigeblock 52 der Abdeckung 50.

Wie in der Fig. 3 gezeigt, werden die Stromsignale von den Hallsensoren 42 und dem oder den Temperaturfühler(n) 44 in Verstärkern 61 verstärkt und einem A/D-Wandler 62 zugeführt. Vom A/D-Wandler 62 gelangen die Signale zu einem Mikroprozessor 63. Zu den Eingangssignalen des Mikroprozessors 63 gehören auch die über einen Tastaturpuffer 64 zugeführten "Tastatur"-Signale. Diese "Tastatur"-Signale sind die über die Knöpfe 54 und/oder den Stecker 56 von außen eingegebenen Steuer- und Kontrollsignale, die festlegen, in welchem Modus der Mikroprozessor 63 arbeiten soll und mit denen innerhalb der einzelnen Moden zum Beispiel Sollwerte für den Strom, Grenzwerte und dergleichen vorgegeben werden können.

Die Programme, nach denen der Mikroprozessor 63 in den einzelnen Betriebsmoden arbeitet, sind entweder im Mikroprozessor 63 selbst oder in separaten Festwertspeichern (nicht gezeigt) gespeichert.

Eine Stromversorqung 65 versorgt die Elektronikkomponenten mit der nötigen Energie.

Im Mikroprozessor 63 werden die Eingangssignale entsprechend dem jeweiligen Betriebsmodus und entsprechend der jeweiligen Vorgaben verarbeitet. Der Mikroprozessor 63 gibt dann in Abhängigkeit vom Ergebnis der Verarbeitung und vom Betriebsmodus an eine LCD-Anzeigesteuerung 66 Steuersignale für die LCD-Anzeige 52, an eine Relais-Ansteuereinheit 67 Schaltsignale und/oder an eine Schnittstelle 68 Daten aller Art für die externe Weitergabe der Daten etwa auf einem Datenbus aus.

Über die Relais-Ansteuereinheit 67 können zum Beispiel, wenn sich das Strommeßgerät in einem Motorschutzmodus befindet, direkt Relais (nicht gezeigt) geschaltet werden, die bei bestimmten Bedingungen (etwa ein hoher Strom über eine zu lange Zeit) die Stromversorgung zum Motor unterbrechen. Zusätzlich oder alternativ kann ein Alarm ausgelöst werden, es kann der zu hohe Strom oder die Abschaltung einer zentralen Steuerstelle gemeldet werden und dergleichen mehr.

## Patentansprüche

1. Strommeßgerät mit einem stromdurchflossenen Leiter (12) in einem isolierenden Gehäuse (10) und einem in der Nähe des Leiters (12) angeordneten Hallsensor, wobei der stromdurchflossene Leiter (12) eine flache Schiene ist, die im Bereich des Hallsensors (42) zu einer u-förmigen Leiterschleife (14) gebogen ist, in welcher der Hallsensor (42) angeordnet ist, **dadurch gekennzeichnet, daß** sich der Hallsensor (42) auf einer Platine (40) befindet, die an einer Hauptplatine (30) angebracht ist, auf der das Signal von dem Hallsensor (42) verarbeitet wird, und daß zwischen dem Gehäuse (10) mit dem stromdurchflossenen Leiter (12) und der Hauptplatine (30) ein isolierender Deckel (20) für das Gehäuse (10) angeordnet ist, der eine isolierende Tasche (22) aufweist, die sich in die Leiterschleife (14) hinein erstreckt und die Platine (40) mit dem Hallsensor (42) aufnimmt.

2. Strommeßgerät nach Anspruch 1, **dadurch gekennzeichnet, daß** die u-förmige Leiterschleife (14) von einer metallischen Abschirmung gegen Magnetfelder umgeben ist.

3. Strommeßgerät nach einem der Ansprüche 1 und 2, **dadurch gekennzeichnet, daß** an der freien Seite der Platine (40), die sich in die Leiterschleife (14) hinein erstreckt, ein Einschnitt (43) vorgesehen ist, in den der Hallsensor (42) senkrecht zur Hauptebene der Platine (40) eingesetzt ist.

4. Strommeßgerät nach einem der vorangehenden Ansprüche, **dadurch gekennzeichnet, daß** an der Platine (40) in unmittelbarer Nähe des Hallsensors (42) ein Temperaturfühler (44) angebracht ist.

5. Strommeßgerät nach einem der vorangehenden Ansprüche, **dadurch gekennzeichnet, daß** über der Hauptplatine (30) eine Abdeckung (50) mit einer Anzeige (52) des durch den Leiter (12) fließenden Stromes angebracht ist.

## Claims

1. Current measuring device having a current carrying conductor (12) in an insulating housing (10) and a Hall sensor arranged in the vicinity of the conductor (12), the current carrying conductor (12) being a flat rail which is bent, in the region of the Hall sensor (42), into a U-shaped conductor loop (14) which contains the Hall sensor (42), **characterized in that** the Hall sensor (42) is located on a circuit board (40) which is fitted on a main circuit board (30) on which the signal from the Hall sensor (42) is processed, and **in that** an insulating cover (20) for the housing (10) is arranged between the housing (10) with the current carrying conductor (12) and the main circuit board (30), said cover having an insulating pocket (22) which extends into the conductor loop (14) and holds the circuit board (40) with the Hall sensor (42).

2. Current measuring device according to Claim 1, **characterized in that** the U-shaped conductor loop (14) is surrounded by a metallic shield against magnetic fields.

3. Current measuring device according to one of Claims 1 and 2, **characterized in that**, on the free side of the circuit board (40) extending into the conductor loop (14), there is an indentation (43) into which the Hall sensor (42) is inserted perpendicularly to the main plane of the circuit board (40).

4. Current measuring device according to one of the preceding claims, **characterized in that** a temperature sensor (44) is fitted on the circuit board (40) in the immediate vicinity of the Hall sensor (42).

5. Current measuring device according to one of the preceding claims, **characterized in that** a covering (50) having a display (52) of the current flowing through the conductor (12) is fitted above the main circuit board (30).

## Revendications

1. Ampèremètre avec un conducteur traversé par le courant (12) dans un boîtier isolant (10) et avec un détecteur à effet hall disposé à proximité du conducteur (12), le conducteur traversé par le courant (12) étant une barre plate, qui est coudée dans la zone du détecteur à effet hall (42) pour former une boucle de conducteur en forme de U (14), dans laquelle est disposé le détecteur à effet hall (42), **caractérisé en ce que** le détecteur à effet hall (42) se trouve sur une platine (40), qui est fixée sur une platine principale (30), sur laquelle est traité le signal du détecteur à effet hall (42) et **en ce qu'**entre le boîtier (10) comprenant le conducteur traversé par le courant (12) et la platine principale (30) est disposé un couvercle isolant (20) pour le boîtier (10), qui comprend une poche isolante (22) s'étendant à l'intérieur de la boucle de conducteur (14) et recevant la platine (40) avec le détecteur à effet hall (42).

2. Ampèremètre ' selon la revendication 1, **caractérisé en ce que** la boucle de conducteur en forme de U (14) est entourée d'un blindage métallique contre les champs magnétiques.

3. Ampèremètre selon l'une des revendications 1 et 2, **caractérisé en ce que** sur le côté libre de la platine (40), qui s'étend à l'intérieur de la boucle de conducteur (14), est prévue une découpe (43), dans laquelle le détecteur à effet hall (42) est placé perpendiculairement au plan principal de la platine (40).

4. Ampèremètre selon l'une des revendications précédentes, **caractérisé en ce que** sur la platine (40), à proximité directe du détecteur à effet hall (42), est disposé un capteur de température (44).

5. Ampèremètre selon l'une des revendications précédentes, **caractérisé en ce qu'**au-dessus de la platine (30) est placé un couvercle (50) avec un indicateur (52) donnant la valeur du courant passant par le conducteur (12).
